# EUROPEAN PATENT APPLICATION

(11) **EP 4 203 312 A1**
(43) Date of publication of application: **28.06.2023**
(21) Application number: 22211988.5
(22) Date of filing: 07.12.2022
(51) Int. Cl.: H03K 3/356

(54) **LOW LEAKAGE LEVEL SHIFTER**

(30) Priority: 23.12.2021 US 202117561037
(71) Applicant: Qorvo US, Inc., Greensboro, NC 27409 (US)
(72) Inventor: VISSER, Hendrik Arend, 3511 SB Utrecht (NL)
(74) Representative: D Young & Co LLP

(57) **Abstract**

A low leakage level shifter circuit (200) converts a lower voltage signal to a higher voltage signal. The level shifter includes a half-latch (206) with an output node (202) that is toggled between the higher voltage (216) and a reference voltage (225) based on an input signal toggled between the lower voltage and the reference voltage. Cross-coupled transistors (208A, 208B) keep one of the output node (202) and a complement node (210) charged to the higher voltage by a charge transistor while the other node is discharged by a discharge transistor (212A, 212B). To discharge the charged node, current through the discharge transistor needs to be higher than current through the charge transistor, but the discharge transistor is only partially turned on by the lower voltage input signal. First and second resistors (R0, R19 coupled between the charge transistors and a voltage source reduce current through the charge transistors, allowing the discharge transistors to be smaller to avoid a high leakage current.

## Description

### Field of the Disclosure

The technology of the disclosure relates generally to voltage conversion, and particularly to a circuit for converting a signal at a first voltage to a signal at a second voltage.

### Background

Significant technological advancements have been made in wireless communication systems to achieve high data throughput, improved coverage range, enhanced signaling efficiency, and reduced latency compared to previous communication systems. Mobile communication devices have become increasingly common in current society for providing wireless communication services. The popularity of mobile communication devices is further driven by evolution from purely communication devices to sophisticated mobile multimedia centers that enable enhanced user experiences. A wide variety of user applications are made possible by combining the advanced communication capabilities of wireless communication systems with high-performance processing in mobile devices. Thus, in addition to analog radio frequency (RF) circuits for wireless communication, mobile communication devices include digital processing circuits for controlling the analog RF circuits, executing application software, and managing data.

With the increased circuitry provided in mobile devices that all consume battery power, advances have been made in digital circuit technology to reduce power consumption to extend battery life. Such advances include reducing the power supply voltage used to power transistors in digital circuits. However, there is still a need for high power circuits, such as power amplifiers for wireless transmission and reception. Higher powered RF circuits can operate at voltage levels that are significantly higher than and may be multiples of the power supply voltage of the digital circuits. Since data received by the analog RF circuits is processed in the digital processing circuits and the processed data is then transmitted back out by the analog RF circuits, there are many points of interaction between digital circuits and analog circuits in a mobile device. Signals generated in the digital circuits at the lower power supply voltage may be too low in voltage for use in the analog RF circuits. Therefore, level shifter circuits are used at interfaces between a first circuit, such as a digital circuit operating at a lower voltage, and a second circuit, such as an analog RF circuit operating at a higher voltage, to convert signals generated in the lower voltage range to the higher voltage range for use in the second circuit. Given the number of level shifter circuits that may be used in a mobile device, it is important to minimize the power consumption of each level shifter circuit.

### Summary

Particular aspects are set out in the appended independent claims. Various optional embodiments are set out in the dependent claims.

Aspects disclosed in the detailed description include a low leakage level shifter circuit. An integrated circuit (IC) including a first circuit, a second circuit, and a level shifter circuit is also disclosed. A level shifter circuit converts a lower voltage signal to a higher voltage signal. The level shifter includes a half-latch with an output node that is toggled between the higher voltage and a reference voltage (e.g., ground) based on an input signal being toggled between the lower voltage and the reference voltage. Cross-coupled transistors of the half-latch keep one of the output node and a complement node charged to the higher voltage while the other node is at the reference voltage. The charged node is discharged by a discharge transistor, and the previously discharged node is allowed to charge through a charge transistor to toggle the half-latch. The discharge transistor needs to discharge the charged node at a rate faster than a charge transistor can provide charge. In this regard, a higher current through the discharge transistor is needed. However, the input signal provided to the gate of the discharge transistors only partially turns on the discharge transistor because the input signal is at the lower voltage. Thus, the discharge transistor conducts only a fraction of its maximum current capacity. To provide the higher current, the discharge transistor can be sized large enough that the fractional current of the discharge transistor, when it is partially turned-on, is able to discharge the charged node, but the leakage current through the discharge transistor increases as it increases in size. In an example aspect, a first resistor and a second resistor are coupled between the charge transistors and a voltage source, providing the higher voltage to the half-latch. The first and second resistors reduce current through the respective charge transistors. In this regard, a smaller current is needed to discharge a node, so discharge transistors of a smaller size can be employed to avoid a large leakage current.

In one example aspect, a level shifter circuit comprising a first transistor, a second transistor, a third transistor, a fourth transistor, a first resistor, and a second resistor is disclosed. The first resistor is coupled between a supply node and a first terminal of the first transistor, and the second resistor is coupled between the supply node and a first terminal of the second transistor. A gate of the first transistor is coupled to a first terminal of the fourth transistor and a second terminal of the second transistor to provide an output node, and a gate of the second transistor is coupled to a first terminal of the third transistor and a second terminal of the first transistor to provide a first node. The output node transitions between a supply voltage provided at the supply node and a reference voltage based on input signals provided to the gate of the third transistor and the gate of the fourth transistor. As the output node transitions from the supply voltage to the reference voltage, the second resistor limits current flow through the second transistor to less than current flow through the fourth transistor to discharge the output node, and as the output node transitions from the reference voltage to the supply voltage, the first resistor limits current flow through the first transistor to less than current flow through the third transistor to discharge the first node.

In another example aspect, an integrated circuit is disclosed. The integrated circuit comprises a first circuit configured to generate a first signal at a first supply voltage, a second circuit configured to receive a second signal at a second supply voltage, and a level shifter circuit configured to convert signals from the first supply voltage to the second supply voltage. A level shifter circuit comprising a first transistor, a second transistor, a third transistor, a fourth transistor, a first resistor, and a second resistor is disclosed. The first resistor is coupled between a supply node and a first terminal of the first transistor, and the second resistor is coupled between the supply node and a first terminal of the second transistor. A gate of the first transistor is coupled to a first terminal of the fourth transistor and a second terminal of the second transistor to provide an output node, and a gate of the second transistor is coupled to a first terminal of the third transistor and a second terminal of the first transistor to provide a first node. The output node transitions between a supply voltage provided at the supply node and a reference voltage based on input signals provided to the gate of the third transistor and the gate of the fourth transistor. As the output node transitions from the supply voltage to the reference voltage, the second resistor limits current flow through the second transistor to less than current flow through the fourth transistor to discharge the output node, and as the output node transitions from the reference voltage to the supply voltage, the first resistor limits current flow through the first transistor to less than current flow through the third transistor to discharge the first node.

In a further example aspect, a level shifter circuit comprising a half-latch is disclosed. The half-latch comprises an output node coupled to a gate of a first charge transistor and an output terminal of a second charge transistor and a complement node coupled to a gate of the second charge transistor, and an output terminal of the first charge transistor. The level shifter circuit further comprises a first discharge transistor coupled to the complement node to discharge the complement node and a second discharge transistor coupled to the output node to discharge the output node. The level shifter circuit comprises a first resistor coupled between an input terminal of the first charge transistor and a supply node to limit current for charging the complement node, and a second resistor coupled between an input terminal of the second charge transistor and the supply node to limit current for charging the output node.

Those skilled in the art will appreciate the scope of the disclosure and realize additional aspects thereof after reading the following detailed description in association with the accompanying drawings.

### Brief Description of the Drawings

The accompanying drawings incorporated in and forming a part of this specification illustrate several aspects of the disclosure and, together with the description, serve to explain the principles of the disclosure.
Figure 1 is a schematic diagram of an existing level shifter circuit for converting an input signal at a lower voltage to a higher voltage on an output node;
Figure 2A is a schematic diagram of an example level shifter circuit including resistors configured to reduce leakage current by reducing a current needed to toggle a voltage at an output node based on the input signal in true and complement form;
Figure 2B is a schematic diagram of an inverter circuit for providing an input signal to a level shifter circuit in true and complement form;
Figure 3 is a block diagram of an integrated circuit including a first circuit generating a lower voltage signal, a second circuit receiving a corresponding signal at a higher voltage, and the level shifter circuit of Figure 2B configured to convert the lower voltage signal to the higher voltage signal; and
Figure 4 is a schematic diagram of the example level shifter circuit in claim 2A, including additional discharge transistors to form cascode circuits for improved performance.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Aspects disclosed in the detailed description include a low leakage level shifter circuit. An integrated circuit including a first circuit, a second circuit, and a level shifter circuit is also disclosed. A level shifter circuit converts a lower voltage signal to a higher voltage signal. The level shifter includes a half-latch with an output node that is toggled between the higher voltage and a reference voltage (e.g., ground) based on an input signal being toggled between the lower voltage and the reference voltage. Cross-coupled transistors of the half-latch keep one of the output node and a complement node charged to the higher voltage while the other node is at the reference voltage. The charged node is discharged by a discharge transistor, and the previously discharged node is allowed to charge through a charge transistor to toggle the half-latch. The discharge transistor needs to discharge the charged node at a rate faster than a charge transistor can provide charge. In this regard, a higher current through the discharge transistor is needed. However, the input signal provided to the gate of the discharge transistors only partially turns on the discharge transistor because the input signal is at the lower voltage. Thus, the discharge transistor conducts only a fraction of its maximum current capacity.

To provide the higher current, the discharge transistor can be sized large enough that the fractional current of the discharge transistor, when it is partially turned-on, is able to discharge the charged node, but the leakage current through the discharge transistor increases as it increases in size. In an example aspect, a first resistor and a second resistor are coupled between the charge transistors and a voltage source, providing the higher voltage to the half-latch. The first and second resistors reduce current through the respective charge transistors. In this regard, a smaller current is needed to discharge a node, so discharge transistors of a smaller size can be employed to avoid a large leakage current.

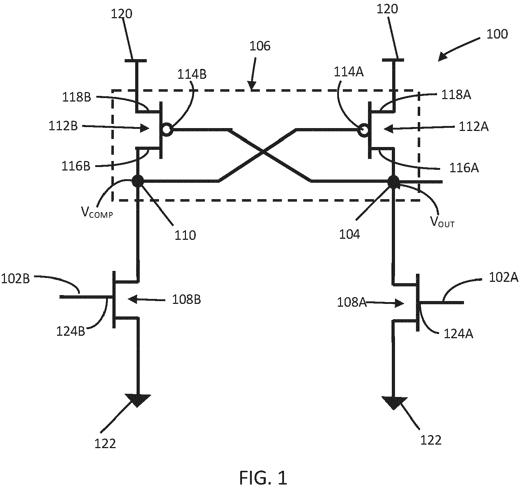

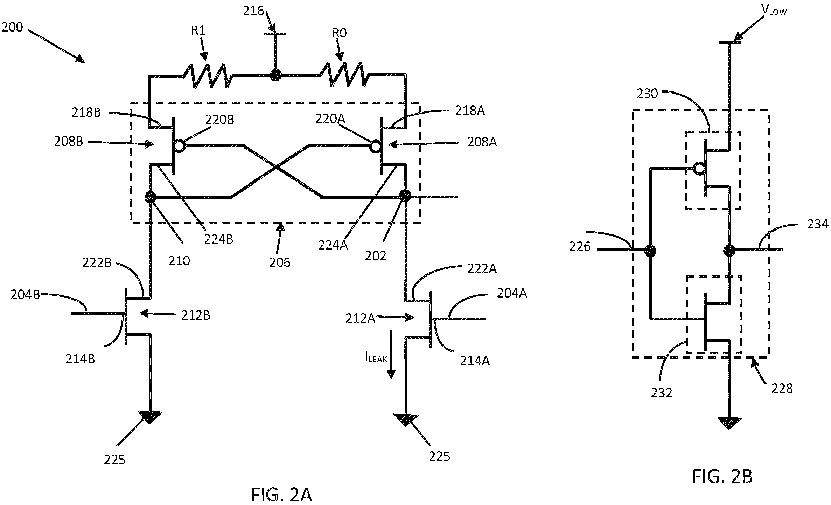

Before discussing an example level shifter circuit illustrated in Figure 2, including resistors coupled to a supply node to reduce leakage current in a discharge transistor, a description of an existing level shifter circuit 100 is provided with reference to the schematic diagram in Figure 1.

Figure 1 is a schematic diagram of the level shifter circuit 100 for converting an input signal 102B, which is at a lower voltage V_{LOW}, to a higher voltage V_{HIGH} as an output voltage V_{OUT} on an output node 104. The output voltage V_{OUT} on the output node 104 is either held stable at the higher voltage V_{HIGH} by a half-latch 106 or held stable at a reference voltage V_{GND} by a discharge transistor 108A. The half-latch 106 is also coupled to a complement node 110 that is kept at a complement voltage V_{COMP} that is complementary to the output voltage V_{OUT}. Specifically, if the output voltage V_{OUT} on the output node 104 is at the higher voltage V_{HIGH}, the complement voltage V_{COMP} on the complement node 110 is at the reference voltage V_{GND} and vice versa.

The half-latch 106 includes cross-coupled charge transistors 112A and 112B. A gate 114A of the charge transistor 112A is coupled to the complement node 110, which is further coupled to a second terminal 116B of the charge transistor 112B. A gate 114B of the charge transistor 112B is coupled to the output node 104, which is further coupled to a second terminal 116A of the charge transistor 112A. The charge transistor 112A includes a first terminal 118A coupled to a supply node 120 and selectively provides the higher voltage V_{HIGH} from the supply node 120 to the output node 104 based on the complement voltage V_{COMP} on the complement node 110. The charge transistor 112B includes a first terminal 118B coupled to the supply node 120 and selectively provides the higher voltage V_{HIGH} to the complement node 110 based on the output voltage V_{OUT} on the output node 104.

The discharge transistor 108A is coupled between the output node 104 and a reference node 122 (e.g., ground) at the reference voltage V_{GND} (e.g., 0V) and discharges the output node 104 to the reference voltage V_{GND} based on an input signal 102A received on a gate 124A of the discharge transistor 108A. A discharge transistor 108B is coupled between the complement node 110 and the reference node 122 and discharges the complement node 110 down to the reference voltage V_{GND} based on an input signal 102B received on a gate 124B of the discharge transistor 108B. The input signals 102A and 102B are complementary to each other. If the input signal 102A is at the lower voltage V_{LOW}, the input signal 102B is at the reference voltage V_{GND}, and if the input signal 102A is at the reference voltage V_{GND}, the input signal 102B is at the lower voltage V_{LOW}. Thus, only one of the discharge transistors 108A and 108B is turned on at a time.

In the above configuration, if the input signal 102B is at the lower voltage V_{Low} and the input signal 102A is at the reference voltage V_{GND}, the discharge transistor 108B is turned on to discharge the complement node 110, and the discharge transistor 108A is turned off. In this state, the discharged complement node 110 is coupled to the reference node 122, bringing the complement voltage V_{COMP} to the reference voltage V_{GND}, which turns on the charge transistor 112A and causes the output node 104 to be at the higher voltage V_{HIGH}. The higher voltage V_{HIGH} on the output node 104 causes the charge transistor 112B to be turned off, maintaining the complement node 110 in a stable state at the reference voltage V_{GND}.

To toggle the output voltage V_{OUT} on the output node 104 from the high voltage V_{HIGH} to the reference voltage V_{GND}, the input signals 102A and 102B are flipped in polarity. With the input signal 102B at the reference voltage V_{GND} and the input signal 102A at the lower voltage V_{LOW}, the discharge transistor 108A is turned on to discharge the output node 104 while the discharge transistor 108B is turned off. In this state, the output node 104 becomes coupled to the reference node 122 while the output node 104 is still coupled to the supply node 120 by the charge transistor 112A. The cross-coupled charge transistors 112A and 112B of the half-latch 106 tend to hold the output voltage V_{OUT} stable. Therefore, immediately after the input signals 102A and 102B switch and the output node 104 is coupled to the reference node 122, the output voltage V_{OUT} is still at the higher voltage V_{HIGH}, and the complement voltage V_{COMP} is at the reference voltage V_{GND}. In this condition, the discharge transistor 108A discharges the output node 104 as the charge transistor 112A continues to charge the output node 104 from the supply node 120.

If the rate at which the discharge transistor 108A discharges the output node 104 is higher than the rate at which the charge transistor 112A charges the output node 104, the output voltage V_{OUT} will begin to decrease. In other words, if the current through the discharge transistor 108A is greater than current through the charge transistor 112A, the output node 104 will discharge. As the output voltage V_{OUT} on the output node 104 decreases, the charge transistor 112B begins to turn on, which begins to charge the complement node 110. In turn, as the complement node 110 begins to charge, the charge transistor 112A begins to turn off, which decreases the current flowing through the charge from the supply node 120 to the output node 104. As this continues, the charge transistor 112B becomes fully turned on, and the complement node 110 is fully charged to the higher voltage V_{HIGH}. Since the input signal 102B is at the reference voltage V_{GND}, the discharge transistor 108B does not discharge the complement node 110. In turn, the charge transistor 112A is fully turned off, and the discharge transistor 108A discharges the output node 104 down to the reference voltage V_{GND}.

The current needed in the discharge transistor 108A in the above scenario to discharge the output node 104 to toggle the output node 104 needs to be greater than a current through the charge transistor 112A. Otherwise, the output node 104 would not become discharged and would not toggle. If the discharge transistor 108A was fully turned on by the input signal 102A, and the maximum current capacity of the discharge transistor 108A is large enough for the needed discharge current, the output node 104 will toggle. However, the discharge transistor 108A needs to be configured with a higher breakdown voltage in order to operate without failure when the higher voltage V_{HIGH} is provided at the first terminal 118A, the reference voltage V_{GND} is provided at the second terminal 116A, and either the lower voltage V_{LOW} or the reference voltage V_{GND} is provided at the gate 114A. The breakdown voltage may be increased by increasing the thickness of a gate oxide.

A consequence of increasing gate oxide thickness is an increase in the voltage needed to fully turn on the transistor. Therefore, the discharge transistors 108A configured to handle the higher voltage V_{HIGH} are not fully turned on by the low voltage V_{LOW} on input signal 102A. To ensure that the discharge transistor 108A conducts sufficient discharge current to toggle the output node 104 when only partially turned on by the lower voltage V_{LOW} on the input signals 102A, 102B, the size of the discharge transistor 108A is increased. However, a consequence of using a larger size discharge transistor is a correspondingly larger leakage current.

Figure 2A is a schematic diagram of an example level shifter circuit 200, including resistors R0 and R1 configured to reduce current leakage by reducing a current needed to toggle (e.g., transition between voltage states) an output voltage V_{OUT} at an output node 202 based on an input signal 204B and complement input signal 204A. The level shifter circuit 200 converts the input signal 204B at a lower voltage V_{LOW} (e.g., 0.6 volts (V)) to a higher voltage V_{HIGH} (e.g., 3.6 V) on the output node 202. The lower voltage V_{LOW} may be any voltage that is lower than the higher voltage V_{HIGH}.

For example, the lower voltage V_{LOW} may be a percentage (e.g., 15%-20%) of the higher voltage V_{HIGH}. The level shifter circuit 200 includes a half-latch 206 coupled to the output node 202, which is toggled between the higher voltage V_{HIGH} and a reference voltage V_{GND} (e.g., 0 V) based on the input signal 204B being toggled between the lower voltage V_{LOW} and the reference voltage V_{GND}. Cross-coupled charge transistors 208A, 208B of the half-latch 206 keep one of the output node 202 and a complement node 210 charged to the higher voltage V_{HIGH} while the other node is at the reference voltage V_{GND}. Toggling the half-latch 206 includes discharging the charged node by one of discharge transistor 212A and discharge transistor 212B and allowing the previously discharged node to charge through one of the charge transistors 208A, 208B.

The terms "charge transistor" and "discharge transistor" as used herein are only intended to be indicative of a function performed by a transistor in the level shifter circuit 200 and not intended to limit physical aspects of the transistors so described. The discharge transistors 212A, 212B need to pass a sufficient current to discharge the charged node at a rate faster than a charge transistor 208A, 208B can provide charge.

The input signals 204A, 204B provided to gates 214A, 214B of the discharge transistors 212A, 212B, which are configured for handling the higher voltage V_{HIGH} do not fully turn on the discharge transistors 212A, 212B. Because the discharge transistors 212A, 212B are only partially turned on by the lower voltage V_{LOW} of the input signals 204A, 204B, the discharge transistors 212A, 212B are sized to have a maximum current capacity much larger than the discharge current.

In an example aspect, the first resistor R0 and the second resistor R1 are coupled between the charge transistors 208A, 208B, and a supply node 216 providing the higher voltage V_{HIGH}. The supply node 216 may be a supply voltage rail. The first and second resistors R0, R1 reduce current through the respective charge transistors 208A, 208B. Consequently, the current needed to discharge a node to toggle the output node 202 of the half-latch 206 is reduced. In this regard, discharge transistors 212A, 212B employed to toggle the output node 202 based on the input signals 204A, 204B can be much smaller in size. Consequently, the leakage current I_{LEAK} through the discharge transistors 212A, 212B is reduced compared to existing level shifter circuits.

To further clarify the structural aspects described above, the level shifter circuit 200 comprises the charge transistor 208A, the charge transistor 208B, the discharge transistor 212A, the discharge transistor 212B, the first resistor R0, and the second resistor R1. The first resistor R0 is coupled between the supply node 216 and a first terminal 218A of the charge transistor 208A. The second resistor R1 is coupled between the supply node 216 and a first terminal 218B of the charge transistor 208B. A gate 220B of the charge transistor 208B is coupled to the output node 202, which is further coupled to a first terminal 222A of the discharge transistor 212A and a second terminal 224A of the charge transistor 208A. A gate 220A of the charge transistor 208A is coupled to the complement node 210, which is further coupled to a first terminal 222B of the discharge transistor 212B and a second terminal 224B of the charge transistor 208B. The output voltage V_{OUT} on the output node 202 transitions ("toggles") between the higher voltage V_{HIGH} provided at the supply node 216 and the reference voltage V_{GND} based on input signals 204A, 204B provided to the gate 214B of the discharge transistor 212B and the gate 214A of the discharge transistor 212A.

As the output voltage V_{OUT} on the output node 202 transitions from the higher voltage V_{HIGH} to the reference voltage V_{GND}, the first resistor R0 limits current flow through the charge transistor 208A to be less than current flow through the discharge transistor 212A to discharge the output node 202. Alternatively, as the output voltage V_{OUT} on the output node 202 transitions from the reference voltage V_{GND} to the supply voltage V_{HIGH}, the second resistor R1 limits current flow through the charge transistor 208B to be less than current flow through the discharge transistor 212B, allowing the discharge transistor 212B to discharge the complement node 210 to a reference node 225.

In the level shifter circuit 200, the output node 202 transitions from the higher voltage V_{HIGH} to the reference voltage V_{GND} in response to the input signal 204a provided to the gate 214A of the discharge transistor 212A transitioning from the reference voltage V_{GND} to the low supply voltage V_{LOW}, which is lower than the higher voltage V_{HIGH} and the input signal 102B provided to the gate 214B of the discharge transistor 212B transitioning from the low voltage V_{LOW} to the reference voltage V_{GND}. The output node 202 transitions in the other direction, from the reference voltage V_{GND} to the higher voltage V_{HIGH} in response to the input signal 204A provided to the gate 214A of the discharge transistor 212A transitioning from the low supply voltage V_{LOW} to the reference voltage V_{GND} and the input signal 204B provided to the gate 214B of the discharge transistor 212B transitioning from the reference voltage V_{GND} to the low voltage V_{LOW}.

The input signals 204A and 204B are binary complements of each other, such that when one is at the lower voltage V_{LOW}, the other is at the reference voltage V_{GND}. An asserted state may correspond to either the low voltage V_{LOW} or the reference voltage V_{GND}. To provide the input signal 204A complementary to the input signal 204B, the input signal 204B is provided to an input 226 of an inverter circuit 228, shown in Figure 2B. The inverter circuit 228 in this example is a complementary metal-oxide-semiconductor (CMOS) inverter including a P-type transistor (e.g., semiconductor doped with trivalent impurity) 230 and an N-type transistor (e.g., semiconductor doped with pentavalent material) 232 coupled in series between the low voltage V_{LOW} and the reference voltage V_{GND}. The input signal 204A as a binary complement of a voltage of the input signal 204B on the input 226 is generated on the output node 234 at which the P-type transistor 230 and the N-type transistor 232 are coupled to each other generates. As an alternative to including the inverter circuit 228 in the level shifter circuit 200, the inverter circuit 228 may be included in a first circuit that generates the input signals 204A, 204B.

With further reference to Figure 2A, the first resistor R0 reduces current in the charge transistor 208A in a first transition direction of the output node 202 from the higher voltage V_{HIGH} to the reference voltage V_{GND} and the second resistor R1 reduces current in the charge transistor 208B in a second transition direction of the output node 202 from the reference voltage V_{GND} to the higher voltage V_{HIGH}. To keep a time of the first transition the same or nearly the same as the second transition, to avoid timing imbalance, the first resistor R0 and the second resistor R1 have the same or similar values. For example, a resistance of the first resistor R0 may be equal to a resistance of the second resistor R1. In some examples, the resistance of the resistor R0 is within five percent (5%) of the resistance of the resistor R1 to ensure timing symmetry in the level shifter circuit 200.

In some examples, the effect of the resistor R0 is to limit current through the charge transistor 208A when the output node 202 is discharging to less than or equal to twenty percent (20%) of a maximum current capacity of the charge transistor 208A. Similarly, the effect of the resistor R1 is to limit current through the charge transistor 208B, when the complement node 210 is discharging, to less than or equal to twenty percent (20%) of a maximum current capacity of the charge transistor 208A. In some examples, the resistances of resistors R0 and R1 are set to limit current through the charge transistor 208B to less than or equal to ten percent (10%) of the maximum current capacity of the charge transistors 208A, 208B.

Increasing the resistances of the resistors R0 and R1 reduces the current through the charge transistors 208A, 208B to have the effect of reducing the sizes of the discharge transistors 212A, 212B to reduce leakage current. However, reducing current through the charge transistors 208A, 208B increases the time required to charge the output node 202 or the complement node 210, which increases the time for toggling the half-latch 206. In this regard, an increase in the resistances of the resistors R0 and R1 can limit the bandwidth of the level shifter circuit 200. Thus, in some examples, the resistances of the resistors R0 and R1 may be in a range from twenty (20) kilohms to forty (40) kilohms and may preferably be in a range from twenty-five (25) kilohms to thirty-five (35) kilohms. To avoid a difference in timing between toggling from the high voltage V_{HIGH} to the reference voltage V_{GND} and from the reference voltage V_{GND} to the high voltage V_{HIGH}, the resistances of the resistors R0 and R1 are the same, or the resistance of the first resistor R0 is within five percent (5%) of the resistance of the second resistor R1.

In some examples, the charge transistors 208A, 208B are P-type metal-oxide-semiconductor (MOS) (PMOS) field-effect transistors (FETS) (MOSFETS), where a semiconductor of a P-type MOSFET is doped with trivalent atoms. In some examples, the discharge transistors 212A, 212B are N-type MOSFETs, where a semiconductor of an N-type MOSFET is doped with pentavalent atoms.

The level shifter circuit 200 may also be described as the half-latch 206, including the output node 202 coupled to the gate 220B of the charge transistor 208B and a second terminal 224B of the charge transistor 208A. The half-latch 206 also includes the complement node 210 coupled to the gate 220A of the charge transistor 208A and the second terminal 224B of the charge transistor 208B. The level shifter circuit 200 also includes the discharge transistor 212B coupled to the complement node 210 to discharge the complement node 210 and the discharge transistor 212A coupled to the output node 202 to discharge the output node 202. The level shifter circuit 200 also includes the resistor R1 coupled between a first terminal 218B of the charge transistor 208B and the supply node 216 to limit current for charging the complement node 210, and the resistor R0 coupled between the first terminal 218B of the charge transistor 208A and the supply node to limit current for charging the output node.

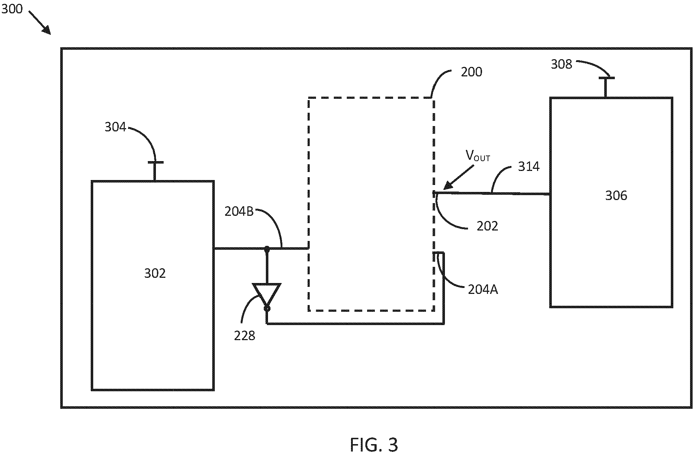

An integrated circuit (IC) 300, as illustrated in Figure 3, may include at least one of the level shifter circuits 200 in Figure 2A for shifting the input signal 204B from the low voltage V_{LOW} to the high voltage V_{HIGH} on the output node 202. The IC 300 comprises a first circuit 302 powered by a first voltage source 304 (e.g., a power rail) at the lower voltage V_{LOW} (e.g., 0.6V) and is configured to generate the input signal 204B at the lower voltage V_{LOW} or at a reference voltage V_{GND}. The first circuit 302 may include digital logic circuits, processing circuits, etc., configured for low power operation in a mobile device, for example. The inverter circuit 228 receives the input signal 204B and generates the input signal 204A.

The IC 300 also includes a second circuit 306 that is powered by a second voltage source 308 at a higher voltage V_{HIGH} and is configured to receive a second signal 310 at the higher voltage V_{HIGH}. The level shifter circuit 200 is configured to convert the first input signal 204B at the lower voltage V_{LOW} to the second signal 310 at the higher voltage V_{HIGH} on the output node 202. The second signal 310 may also be provided on the output node 202 at the reference voltage V_{GND} in response to the first input signal 204B being at the reference voltage V_{GND}.

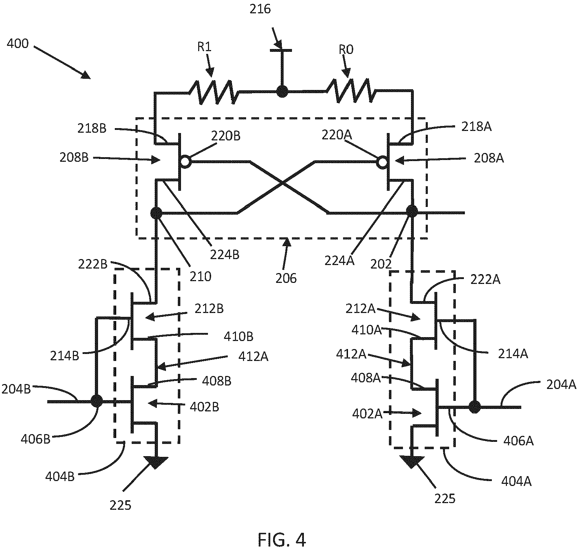

Figure 4 is a schematic diagram of an example level shifter circuit 400, which corresponds to the level shifter circuit 200 in Figure 2A except as detailed below. In particular, the level shifter circuit 400 includes discharge transistors 402A and 402B coupled in series with the discharge transistors 212A and 212B, respectively, to form cascode circuits 404A and 404B for improved discharging performance compared to the level shifter circuit 200 in Figure 2A. A gate 406A of the discharge transistor 402A and the gate 214A of the discharge transistor 212A both receive the input signal 204A. A first terminal 408A of the discharge transistor 402A is coupled to a second terminal 410A of the discharge transistor 212A to provide a discharge path for discharging the output node 202. A gate 406B of the discharge transistor 402B and the gate 214B of the discharge transistor 212B both receive the input signal 204B. A first terminal 408B of the discharge transistor 402B is coupled to a second terminal 410B of the discharge transistor 212B to provide a discharge path for discharging the first complement node 210.

Discharging the output node 202 includes providing the input signal 204A at the lower voltage V_{LOW} to the gate 406A of the discharge transistor 402A and to the gate 214A of the discharge transistor 212A. Discharging the complement node 210 includes providing the input signal 204B at the lower voltage V_{LOW} to the gate 406B of the discharge transistor 402B and to the gate 214B of the discharge transistor 212B.

In contrast to the discharge transistor 212A in Figure 2A, which is configured to discharge the output node 202 from the higher voltage V_{HIGH} to the reference voltage V_{GND}, the cascode circuit 404A includes the discharge transistor 212A to discharge from the higher voltage V_{HIGH} of the output node 202 to an intermediate voltage 412A. The discharge transistors 402A discharges the intermediate voltage 412A to the reference voltage V_{GND}. Therefore, the discharge transistors 212A and 402A in Figure 4 can each be configured for lower voltages than the discharge transistor 212A in Figure 2A. In this regard, the input signal 204A can turn on the discharge transistors 212A and 402A in Figure 4 to a greater extent than the discharge transistor 212A in Figure 2A is turned on. In this regard, the cascode circuit 404A conducts a larger current for discharging the output node 202 in response to the lower voltage V_{LOW} than is possible with only the discharge transistor 212A in Figure 2A. The output node 202 of the level shifter circuit 400 in Figure 4 discharges more quickly than the output node 202 of the level shifter circuit 200 in Figure 2A for increased performance.

Therefore, from one perspective, there have been described approaches by which a low leakage level shifter circuit converts a lower voltage signal to a higher voltage signal. The level shifter includes a half-latch with an output node that is toggled between the higher voltage and a reference voltage based on an input signal toggled between the lower voltage and the reference voltage. Cross-coupled transistors keep one of the output node and a complement node charged to the higher voltage by a charge transistor while the other node is discharged by a discharge transistor. To discharge the charged node, current through the discharge transistor needs to be higher than current through the charge transistor, but the discharge transistor is only partially turned on by the lower voltage input signal. First and second resistors coupled between the charge transistors and a voltage source reduce current through the charge transistors, allowing the discharge transistors to be smaller to avoid a high leakage current.

Further examples are set out in the following numbered clauses:
Clause 1. A level shifter circuit comprising a first transistor, a second transistor, a third transistor, a fourth transistor, a first resistor, and a second resistor, wherein: the first resistor is coupled between a supply node and a first terminal of the first transistor; the second resistor is coupled between the supply node and a first terminal of the second transistor; a gate of the first transistor is coupled to a first terminal of the fourth transistor and a second terminal of the second transistor to provide an output node; a gate of the second transistor is coupled to a first terminal of the third transistor and a second terminal of the first transistor to provide a first node; the output node transitions between a supply voltage provided at the supply node and a reference voltage based on input signals provided to a gate of the third transistor and a gate of the fourth transistor; as the output node transitions from the supply voltage to the reference voltage, the second resistor limits current flow through the second transistor to be less than current flow through the fourth transistor to discharge the output node; and as the output node transitions from the reference voltage to the supply voltage, the first resistor limits current flow through the first transistor to be less than current flow through the third transistor to discharge the first node.
Clause 2. The level shifter circuit of clause 1, wherein the output node transitions from the supply voltage to the reference voltage in response to the input signal provided to the gate of the fourth transistor transitioning from the reference voltage to a low supply voltage lower than the supply voltage and the input signal provided to the gate of the third transistor transitioning from the low supply voltage to the reference voltage.
Clause 3. The level shifter circuit of clause 2, wherein the output node transitions from the reference voltage to the supply voltage in response to the input signal provided to the gate of the third transistor transitioning from the low supply voltage lower than the supply voltage to the reference voltage and the input signal provided to the gate of the fourth transistor transitioning from the reference voltage to the low supply voltage.
Clause 4. The level shifter circuit of clause 3, further comprising an inverter circuit comprising an inverter input coupled to the gate of the third transistor and an inverter output coupled to the gate of the fourth transistor.
Clause 5. The level shifter circuit of any preceding clause, further comprising a fifth transistor and a sixth transistor, wherein: a second terminal of the third transistor is coupled to a first terminal of the fifth transistor; the first node is discharged through the fifth transistor; a second terminal of the fourth transistor is coupled to a first terminal of the sixth transistor; and the output node is discharged through the sixth transistor.
Clause 6. The level shifter circuit of clause 5, wherein: the gate of the third transistor is coupled to a gate of the fifth transistor; and the gate of the fourth transistor is coupled to a gate of the sixth transistor.
Clause 7. The level shifter circuit of any preceding clause, wherein a first resistance of the first resistor is within five percent (5%) of a second resistance of the second resistor.
Clause 8. The level shifter circuit of any preceding clause, wherein: as the output node transitions from the supply voltage to the reference voltage, the first resistor limits current flow through the first transistor to be less than twenty percent (20%) of a current capacity of the first transistor; and as the output node transitions from the reference voltage to the supply voltage, and the second resistor limits current in the second transistor to less than twenty percent (20%) of a current capacity of the second transistor.
Clause 9. The level shifter circuit of any preceding clause, wherein: the first and second transistors are P-type metal-oxide-semiconductor (MOS) (PMOS) transistors; and the third and fourth transistors are N-type MOS (NMOS) transistors.
Clause 10. The level shifter circuit of any preceding clause, wherein each of the first resistor and the second resistor is in a range from twenty (20) kilohms to forty (40) kilohms.
Clause 11. An integrated circuit comprising a first circuit configured to generate a first signal at a first supply voltage, a second circuit configured to receive a second signal at a second supply voltage, and a level shifter circuit configured to convert signals from the first supply voltage to the second supply voltage, the level shifter circuit comprising a first transistor, a second transistor, a third transistor, a fourth transistor, a first resistor, and a second resistor, wherein: the first resistor is coupled between a supply node and a first terminal of the first transistor; the second resistor is coupled between the supply node and a first terminal of the second transistor; a gate of the first transistor is coupled to an output node coupled to a first terminal of the fourth transistor and a second terminal of the second transistor; a gate of the second transistor is coupled to a first node coupled to a first terminal of the third transistor and a second terminal of the first transistor; the output node transitions between a supply voltage provided at the supply node and a reference voltage based on input signals provided to a gate of the third transistor and a gate of the fourth transistor; as the output node transitions from the supply voltage to the reference voltage, the second resistor limits current flow through the second transistor to be less than current flow through the fourth transistor to discharge the output node; and as the output node transitions from the reference voltage to the supply voltage, the first resistor limits current flow through the first transistor to be less than current flow through the third transistor to discharge the first node.
Clause 12. The integrated circuit of clause 11, wherein the output node transitions from the supply voltage to the reference voltage in response to the input signal provided to the gate of the third transistor transitioning from the reference voltage to a low supply voltage lower than the supply voltage and the input signal provided to the gate of the fourth transistor transitioning from the low supply voltage to the reference voltage.
Clause 13. The integrated circuit of clause 12, wherein the output node transitions from the reference voltage to the supply voltage in response to the input signal provided to the gate of the third transistor transitioning from the low supply voltage lower than the supply voltage to the reference voltage and the input signal provided to the gate of the fourth transistor transitioning from the reference voltage to the low supply voltage.
Clause 14. The integrated circuit of clause 13, further comprising an inverter circuit comprising an inverter input coupled to the gate of the third transistor and an inverter output coupled to the gate of the fourth transistor.
Clause 15. The integrated circuit of any of clauses 11 to 14, further comprising a fifth transistor and a sixth transistor, wherein: the second terminal of the third transistor is coupled to a first terminal of the fifth transistor; the first node is discharged through the fifth transistor; the second terminal of the fourth transistor is coupled to a first terminal of the sixth transistor; and the output node is discharged through the sixth transistor.
Clause 16. The integrated circuit of clause 15, wherein: the gate of the third transistor is coupled to a gate of the fifth transistor; and the gate of the fourth transistor is coupled to a gate of the sixth transistor.
Clause 17. The level shifter circuit of any of clauses 11 to 16, wherein: as the output node transitions from the supply voltage to the reference voltage, the first resistor limits current flow through the first transistor to be less than twenty percent (20%) of a current capacity of the first transistor; and as the output node transitions from the reference voltage to the supply voltage, and the second resistor limits current in the second transistor to less than twenty percent (20%) of a current capacity of the second transistor.
Clause 18. The integrated circuit of any of clauses 11 to 17, wherein: the first and second transistors are P-type metal-oxide-semiconductor (MOS) (PMOS) transistors; and the third and fourth transistors are N-type MOS (NMOS) transistors.
Clause 19. A lever shifter circuit comprising: a half-latch circuit comprising: an output node coupled to a gate of a first charge transistor and an output terminal of a second charge transistor; and a complement node coupled to a gate of the second charge transistor and an output terminal of the first charge transistor; a first discharge transistor coupled to the complement node to discharge the complement node; a second discharge transistor coupled to the output node to discharge the output node; a first resistor coupled between an input terminal of the first charge transistor and a supply node to limit current for charging the complement node; and a second resistor coupled between an input terminal of the second charge transistor and the supply node to limit current for charging the output node.
Clause 20. The level shifter circuit of clause 19, further comprising: a third discharge transistor coupled between the first discharge transistor and a reference node to discharge the complement node; and a fourth discharge transistor coupled between the second discharge transistor and the reference node to discharge the output node.
Clause 21. The level shifter circuit of clause 20, wherein: the gate of the first discharge transistor is coupled to a gate of the third discharge transistor; and the gate of the second discharge transistor is coupled to a gate of the fourth discharge transistor.
Those skilled in the art will recognize improvements and modifications to the embodiments of the present disclosure. All such improvements and modifications are considered within the scope of the concepts disclosed herein and the claims that follow.

## Claims

1. A level shifter circuit comprising a first transistor, a second transistor, a third transistor, a fourth transistor, a first resistor, and a second resistor, wherein:
the first resistor is coupled between a supply node and a first terminal of the first transistor;
the second resistor is coupled between the supply node and a first terminal of the second transistor;
a gate of the first transistor is coupled to a first terminal of the fourth transistor and a second terminal of the second transistor to provide an output node;
a gate of the second transistor is coupled to a first terminal of the third transistor and a second terminal of the first transistor to provide a first node;
the output node transitions between a supply voltage provided at the supply node and a reference voltage based on input signals provided to a gate of the third transistor and a gate of the fourth transistor;
as the output node transitions from the supply voltage to the reference voltage, the second resistor limits current flow through the second transistor to be less than current flow through the fourth transistor to discharge the output node; and
as the output node transitions from the reference voltage to the supply voltage, the first resistor limits current flow through the first transistor to be less than current flow through the third transistor to discharge the first node.

2. The level shifter circuit of claim 1, wherein the output node transitions from the supply voltage to the reference voltage in response to the input signal provided to the gate of the fourth transistor transitioning from the reference voltage to a low supply voltage lower than the supply voltage and the input signal provided to the gate of the third transistor transitioning from the low supply voltage to the reference voltage.

3. The level shifter circuit of claim 2, wherein the output node transitions from the reference voltage to the supply voltage in response to the input signal provided to the gate of the third transistor transitioning from the low supply voltage lower than the supply voltage to the reference voltage and the input signal provided to the gate of the fourth transistor transitioning from the reference voltage to the low supply voltage.

4. The level shifter circuit of claim 3, further comprising an inverter circuit comprising an inverter input coupled to the gate of the third transistor and an inverter output coupled to the gate of the fourth transistor.

5. The level shifter circuit of any preceding claim, further comprising a fifth transistor and a sixth transistor, wherein:
a second terminal of the third transistor is coupled to a first terminal of the fifth transistor;
the first node is discharged through the fifth transistor;
a second terminal of the fourth transistor is coupled to a first terminal of the sixth transistor; and
the output node is discharged through the sixth transistor.

6. The level shifter circuit of claim 5, wherein:
the gate of the third transistor is coupled to a gate of the fifth transistor; and
the gate of the fourth transistor is coupled to a gate of the sixth transistor.

7. The level shifter circuit of any preceding claim, wherein a first resistance of the first resistor is within five percent (5%) of a second resistance of the second resistor.

8. The level shifter circuit of any preceding claim, wherein:
as the output node transitions from the supply voltage to the reference voltage, the first resistor limits current flow through the first transistor to be less than twenty percent (20%) of a current capacity of the first transistor; and
as the output node transitions from the reference voltage to the supply voltage, and the second resistor limits current in the second transistor to less than twenty percent (20%) of a current capacity of the second transistor.

9. The level shifter circuit of any preceding claim, wherein:
the first and second transistors are P-type metal-oxide-semiconductor (MOS) (PMOS) transistors; and
the third and fourth transistors are N-type MOS (NMOS) transistors.

10. The level shifter circuit of any preceding claim, wherein each of the first resistor and the second resistor is in a range from twenty (20) kilohms to forty (40) kilohms.

11. An integrated circuit comprising a first circuit configured to generate a first signal at a first supply voltage, a second circuit configured to receive a second signal at a second supply voltage, and the level shifter circuit of any preceding claim configured to convert signals from the first supply voltage to the second supply voltage.

12. A lever shifter circuit comprising:
a half-latch circuit comprising:
an output node coupled to a gate of a first charge transistor and an output terminal of a second charge transistor; and
a complement node coupled to a gate of the second charge transistor and an output terminal of the first charge transistor;
a first discharge transistor coupled to the complement node to discharge the complement node;
a second discharge transistor coupled to the output node to discharge the output node;
a first resistor coupled between an input terminal of the first charge transistor and a supply node to limit current for charging the complement node; and
a second resistor coupled between an input terminal of the second charge transistor and the supply node to limit current for charging the output node.

13. The level shifter circuit of claim 12, further comprising:
a third discharge transistor coupled between the first discharge transistor and a reference node to discharge the complement node; and
a fourth discharge transistor coupled between the second discharge transistor and the reference node to discharge the output node.

14. The level shifter circuit of claim 13, wherein:
the gate of the first discharge transistor is coupled to a gate of the third discharge transistor; and
the gate of the second discharge transistor is coupled to a gate of the fourth discharge transistor.
